Europäisches Patentamt

European Patent Office

Office européen des brevets

(19)

(11) Publication number: **0 175 572**
A2

# EUROPEAN PATENT APPLICATION

(12)

(21) Application number: 85306614.0

(22) Date of filing: 17.09.85

(51) Int. Cl.⁴: **G 03 F 1/04**, G 03 C 11/14

(30) Priority: 21.09.84 AU 7248/84

(43) Date of publication of application: 26.03.86
Bulletin 86/13

(84) Designated Contracting States: **AT BE CH DE FR GB IT LI LU NL SE**

(71) Applicant: **OBERVIEW PTY. LTD., 53-55 Herbert Street, Artarmon New South Wales (AU)**

(72) Inventor: **Connell, Bruce Ronald, 92 Edgecliffe Boulevard, Collaroy Plateau New South Wales (AU)**

(74) Representative: **Mair, Richard Douglas et al, F.J. Cleveland & Company 40-43 Chancery Lane, London WC2A 1JQ (GB)**

(54) **Print mounting.**

(57) A method of attaching a photographic or other print to a face of a sheet of clear, preferably rigid, supporting material such as «PERSPEX», glass or other transparent plastic material which consists in coating either the print or the supporting material or both with a radiation curable adhesive which after curing remains permanently pressure sensitive and flexible to permit differential contraction and expansion of the print and the supporting material with changes in ambient temperature, subjecting the print and supporting material to pressure by rollers or otherwise to press the print to the supporting material and form a substantially uniform air-free layer of adhesive between the print and the support and subjecting the assembly to heat and/or radiation to cure the adhesive.

Print Mounting

The present invention relates to a method of mounting prints such as are produced by photographic colour reproduction or a printing process such as off-set printing.

In commercial advertising there is a requirement for the mounting of a print on a surface of a transparent sheet material such as polymethyl methacrylate sold under the registered trade mark "PERSPEX" or other clear sheet plastic material on glass so that the print is viewed through the sheet. Prints so mounted would have a very attractive appearance and would be suitable for handling and mounting in a variety of situations.

There have been found, however, to be a number of substantial difficulties in achieving the desired result. The principal of these lies in the necessity for causing the print to adhere to the covering material in such a manner that no air is trapped between the print and the supporting material. Air enclosures give the finished article a very unattractive appearance. A further difficulty arises due to the different co-efficients of expansion and contraction of the print and the supporting material. Further difficulties have been found in finding an adhesive that meets the requirements set out above and is also long lasting in use.

The present invention provides a method of mounting prints to a transparent supporting material which overcomes the difficulties described.

The present invention consists in a method of attaching a photographic or other print to a face of a sheet of clear, preferably rigid, supporting material such as "PERSPEX", glass or other transparent plastic material which consists in coating either the print or the supporting material or both with a radiation curable adhesive which after curing remains permanently pressure sensitive and flexible to permit differential contraction and expansion of the print and the supporting material with changes in ambient temperature, subjecting the print and supporting material to pressure by rollers or ·, otherwise to press the print to the supporting material and form a substantially uniform air-free layer of adhesive between the print and the support and subjecting the assembly to heat and/or radiation to cure the adhesive.

The present invention further comprises a print adhered to a clear supporting material by the method defined above.

In the application of the invention a photographic colour reproduction of the appropriate size is prepared as is a suitably sized sheet of "PERSPEX". The face of the print is then coated with an adhesive consisting of a monomer that is polymerisable by ultra-violet radiation sold by Monocure Pty. Ltd. a New South Wales company under the designation 'Under Cover Varnish' so as to produce an approximately even coat over the whole surface of the print. The print and the "PERSPEX" sheet are then passed through squeegee rollers to press them together and cause the adhesive to form an even air-free layer between them. In practice small quantities of surplus adhesive are squeezed out around the edges of the assembly. At this stage it is most important to ensure that all air is driven out because even small quantities can produce an unacceptable blemish in the finished product.

The edges of the assembly are then exposed to curing lamps to cure the adhesive adjacent the edges. This enables the assembly to be handled while the protective coating of paper is removed from the front face of the "PERSPEX" sheet. Curing of the remainder is then completed. As is well known "PERSPEX" provides a fairly effective barrier to the passage of ultra-violet radiation. It is, however, the case that the adhesive used will cure at low rates of exposure to ultra-violet and  thus the presence of the "PERSPEX" does not provide any obstacle to curing.

After curing the adhesive has the property of remaining in a tacky semi-liquid form.  It has sufficient strength to hold the print to the "PERSPEX" sheet but on the other hand will allow differential expansion and contraction of the two without visible result.  In addition the combination of the adhesive and the "PERSPEX" sheet gives excellent protection to the print against degradation under the influence of ultra-violet radiation.

The most satisfactory results have been produced using an adhesive produced by Three Bond Co., Ltd., of Tokyo, Japan under that company's reference TB3031 characteristics of which are set out in the following table:

|  | TB3031 |
|---|---|
| Appearance | Light brown, transparent 5000 |
| Viscosity ($25^{\circ}$C, cps.) | 5000 |
| Specific gravity ($25^{\circ}$C) | 1.05 |
| Non-volatile matter (%) | over 99 |
| Tensile adhesive strength ($kg/cm^2$, Glass/Fe) | 80 -120 |
| Tensile strength ($kg/mm^2$) | 2.5 - 2.7 |
| Hardness ($25^{\circ}$C, Shore) | D:70 - 75 |
| Volume resistance ($\Omega$-cm) | $8.1 \times 10^{13}$ |
| Surface resistance ($\Omega$) | $7.2 \times 10^{13}$ |
| Dielectric constant (50HZ) | 7.34 |
| tan $\delta$ (50HZ) | 0.026 |
| Elongation (%) | 20 |
| Thermal expansion coefficient ($cm/^{\circ}$C) | $9.5 \times 10^{-5}$ |
| Reference | For adhesion. Flexible. Resistant to cold temp. Good adhesiveness. |

This adhesive was applied by means of a Mayer bar which consists of a bar wound round with wire that is used to transfer the adhesive from the bar onto either the print or the substrate to form a uniform layer. The print and the substrate are then united as described above. This adhesive cures by exposure to ultra-violet radiation which may be provided by a mercury lamp of 100 watt capacity with which irradiation time at a distance of 20 cm is of the order of 60 seconds.

The sheet on which the print is mounted may be flat or curved and may be of any desired thickness depending on the intended application.

It has been found that the procedure described above result in the production of extremely satisfactory results meeting all the requirements set out above.

## CLAIMS

1. A method of attaching a print to a face of a sheet of clear supporting material which consists in coating at least one of said print or said supporting material with a radiation curable adhesive which after curing remains permanently pressure sensitive and flexible to permit differential contraction and expansion of the print and the supporting material with changes in ambient temperature, subjecting the prints and supporting material to pressure to press the print to the supporting material and form substantially uniform air free layer of adhesive between the print and the support and subjecting the assembly to radiation to cure the adhesive.

2. A method as claimed in claim 1, wherein the adhesive is adhesive manufactured by Three Bond Co., Ltd. and identified by that company's reference TB3031.

3. A method as claimed in claim 1 or claim 2, wherein the edges of the assembled print and supporting material are subjected to radiation in a first step to cure the adhesive adjacent the edges, curing of the remainder being carried out subsequently.

4. A print adhered to a clear supporting material by the method defined in claim 1.

5. A print as claimed in claim 4, wherein the print is a photographic colour reproduction and the supporting material is a sheet of polymethyl methacrylate.